# FASCICULE DE BREVET EUROPEEN

(11) **EP 0 771 031 B1**
(45) Date de publication et mention de la délivrance du brevet: **12.03.2003**
(21) Numéro de dépôt: 96402285.9
(22) Date de dépôt: 25.10.1996
(51) Int. Cl.: H01L 27/02

(54) **Circuit intégré de régulateur de la tension de charge d'une batterie par un alternateur, notamment dans un véhicule automobile**
Integrierter Ladungsspannungsregler für die Ladung einer Batterie durch einen Generator, insbesondere für ein Auto
Integrated circuit regulating the charge voltage of a battery by an alternator, especially in vehicles

(30) Priorité: 25.10.1995 FR 9512573
(43) Date de publication de la demande: 02.05.1997
(73) Titulaire: VALEO EQUIPEMENTS ELECTRIQUES MOTEUR, 94000 Creteil (FR)
(72) Inventeur: Pierret, Jean-Marie, 75012 Paris (FR)
(74) Mandataire: Le Forestier, Eric

(56) Documents cités:
- FR-A- 2 624 320
- GB-A- 1 457 586

## Description

La présente invention concerne le domaine des circuits intégrés de régulateurs pour alternateurs de véhicules automobiles.

Un tel régulateur commande un inducteur de l'alternateur pour en modifier l'excitation, contrôlant ainsi la tension de sortie de l'alternateur, donc la tension de charge de la batterie. Un régulateur connu comporte un étage d'excitation couramment réalisé en technologie MOS (Semiconducteur à grille isolée par Oxyde Métallique).

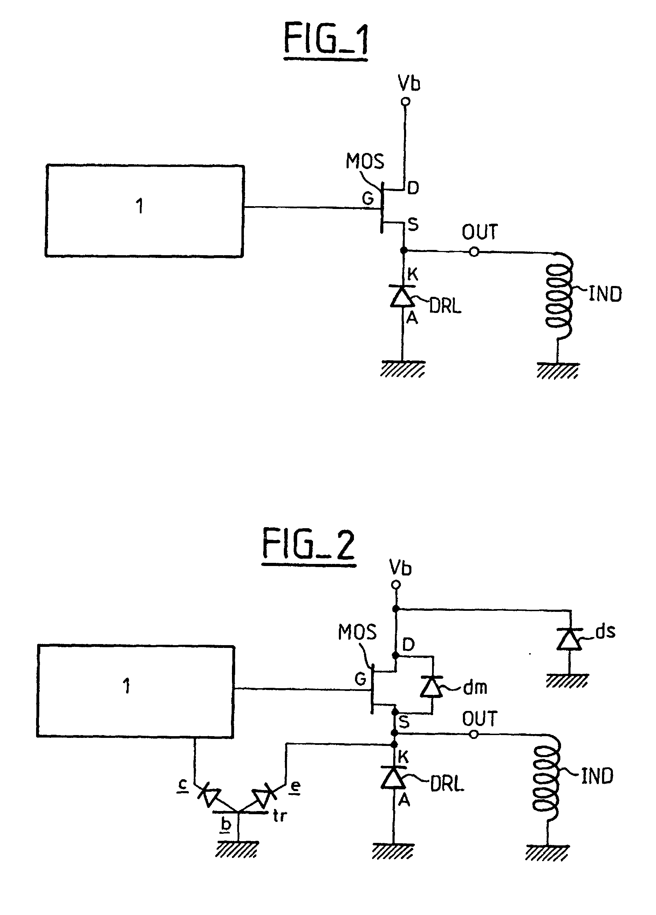

La figure 1 représente un schéma électrique connu de circuit intégré d'étage d'excitation de régulateur.

Le circuit, intégré sur une puce en silicium unique, de régulateur pour la commande du courant d'excitation dans une inductance IND de l'alternateur, comporte une borne de sortie OUT reliée à l'inductance IND, une première et une seconde bornes d'alimentation, reliées chacune à une borne respective d'une batterie électrique, le circuit comprenant un transistor MOS à effet de champ intégré sur la puce, disposé entre la première borne d'alimentation Vb et la borne de sortie OUT, une unité de commande 1 intégrée sur la puce, commandant le transistor MOS à effet de champ, et une diode de roue libre DRL également intégrée sur la puce, disposée entre la seconde borne d'alimentation (masse) et la borne de sortie OUT.

Conventionnellement, la tension Vb est la tension positive de batterie, l'autre borne étant connectée à la masse du véhicule. Les deux bornes d'alimentation de ce circuit sont reliées (de façon non représentée), d'une part, aux bornes respectives de la batterie et, d'autre part, aux bornes respectives de sortie d'un pont redresseur de l'alternateur.

En fonctionnement, l'unité de commande 1 active, régulièrement, le transistor MOS à effet de champ qui alimente alors l'inductance IND sous, sensiblement, la tension Vb.

Lorsque le transistor MOS est bloqué, le courant qui traverse alors l'inductance IND est dérivé dans la diode de roue libre DRL. L'excitation de l'alternateur est ainsi lissée et des surtensions sont évitées.

Lorsque le circuit intégré de la figure 1 est implanté en technologie horizontale sur une puce en silicium, il apparaît plusieurs diodes parasites, comme illustré sur le schéma équivalent de la figure 2.

On rappellera ici que la technologie horizontale consiste à réaliser toutes les connexions utiles du circuit sur une seule face de celui-ci, le substrat situé du côté opposé étant à un potentiel fixe, généralement à la masse. Par opposition, la technologie dite verticale consiste à réaliser au moins certains composants dans l'épaisseur du substrat, avec par conséquent des connexions sur ses deux faces.

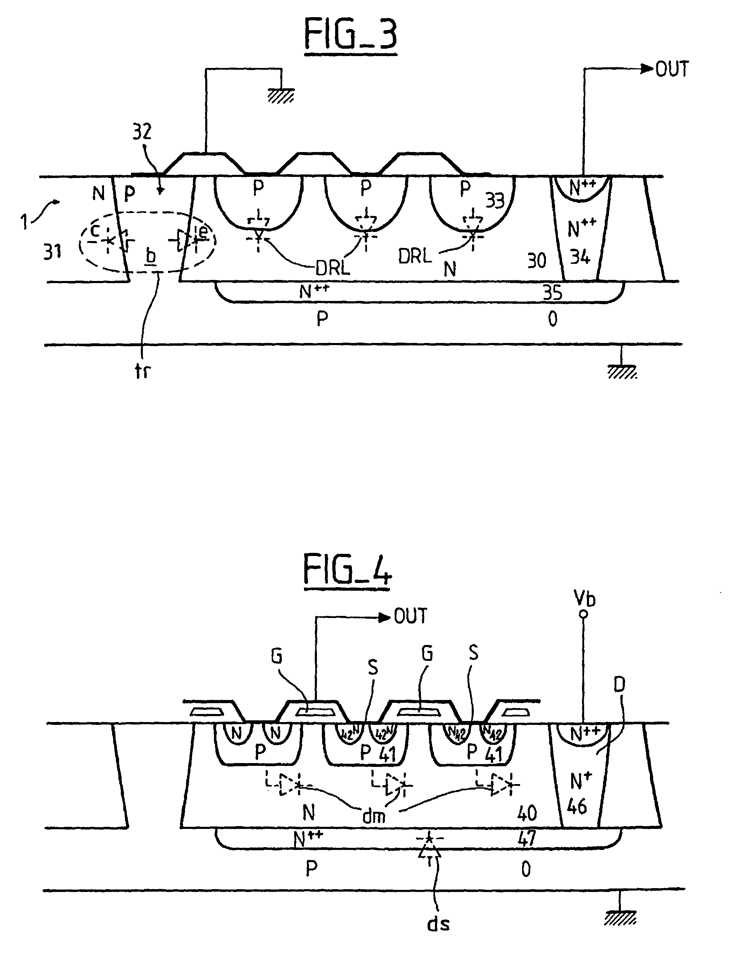

En référence à la figure 4, on observe que le transistor à effet de champ MOS constitué par les parties 40, 41, 42, 46 et 47, qui doit commander un fort courant, présente donc une surface importante. Par conséquent, il présente, entre sa source S et son drain D, une diode inverse dm faiblement résistive.

Il existe par ailleurs un effet de transistor parasite entre l'unité de commande 1, la masse et la borne de sortie OUT.

Cet effet de transistor se comprend en observant la figure 3 qui représente l'implantation de la diode DRL sur une puce d'un circuit intégré connu de régulateur.

A la figure 3, on voit par exemple que l'unité de commande 1 est implantée dans une poche 31 de type N qui est séparée par un mur d'isolement 32 de type P d'une autre poche 30 de type N où est implantée la diode de roue libre DRL. Il peut donc y avoir un effet dé transistor bipolaire NPN entre l'unité de commande 1 et la borne de sortie OUT. Ce transistor parasite tr est représenté aux figures 2 et 3.

Si une chute de tension directe importante apparaissait aux bornes de la diode de *roue* libre DRL, un courant apparaîtrait dans ce transistor parasite tr et perturberait ou détruirait l'unité de commande 1.

Pour maintenir ce transistor parasite tr à l'état bloqué, la diode de roue libre DRL doit donc être faiblement résistive.

Enfin il existe une diode substrat ds entre le substrat de la puce et le drain du transistor MOS. Cette diode est, par construction, fortement résistive pour les basses températures, mais faiblement résistive à chaud.

En fonctionnement normal, la tension Vb est positive. Mais, la polarité de la batterie peut être inversée, par erreur, lors de son branchement sur le véhicule.

Dans ce cas, la tension Vb appliquée au régulateur subit une inversion de polarité. Les diodes de puissance du pont redresseur sont alors polarisées en direct et font chuter la tension batterie Vb à une valeur inférieure ou égale à -3,2 volts au niveau du régulateur.

Mais cette faible tension inverse amène la diode de roue libre DRL, la diode inverse dm du transistor-MOS à effet de champ et la diode substrat ds à être traversées par un très fort courant car elles sont faiblement résistives.

Généralement, l'opérateur constate immédiatement son erreur et déconnecte la batterie.

Mais si l'inversion de polarité est maintenue pendant quelques secondes, les régulateurs connus sont très vite détruits par le court-circuit.

La puce du circuit intégré est connectée en effet à des broches de contact par des fils métalliques très fins appelés bondings. Les bondings sont souvent détruits instantanément par le courant important provoqué par une inversion de batterie. Pour résister à ce fort courant, il faut multiplier le nombre de bondings que l'on connecte en parallèle ou augmenter leur section. Ces deux solutions compliquent considérablement la fabrication du circuit intégré et son coût est augmenté.

Un inconvénient des circuits intégrés de régulateurs connus est donc leur faible tenue à l'inversion de polarité.

On connaît certes par le document FR-A-2 624 320, qui reprend les caractéristiques du préambule de la revendication 1, un circuit intégré de régulateur qui, pour pallier ces inconvénients, prévoit d'incorporer au circuit intégré une résistance de faible valeur en série avec la diode de roue libre, ceci afin de diminuer le courant susceptible de traverser le circuit en cas d'inversion de polarité.

Ce document prévoit d'implanter cette résistance soit entre la cathode de la diode de roue libre et la borne de sortie d'excitation, soit entre l'anode de la diode et la masse.

Toutefois, seule la seconde de ces solutions est décrite dans ce document, et la réalisation, par analogie, de la première solution dans le cas d'une technologie horizontale n'aurait rien d'immédiat pour l'homme du métier; en effet il serait dans ce cas impossible d'utiliser la matière du substrat P pour réaliser l'isolement requis entre la résistance et la poche ou le caisson auquel elle doit être reliée, car ce substrat est à un potentiel fixe tel que la masse.

Or c'est précisément cette première solution qui, dans un circuit réalisé en technologie horizontale, permettrait de pallier les inconvénients précités. Plus précisément, ce sera seulement si la résistance est prévue entre la cathode de la diode de roue libre et la borne de sortie d'excitation que l'on pourra éviter l'apparition de l'effet de transistor parasite tr précité.

La présente invention a donc pour objet d'améliorer la tenue à l'inversion de polarité d'un circuit intégré de régulateur réalisé en technologie verticale, et ceci sans augmenter sensiblement la surface de la puce, et d'une manière extrêmement simple et économique.

Ces buts sont atteints, selon l'invention, grâce aux caractéristiques de la revendication 1.

Des aspects préférés, mais non limitatifs, de la présente invention sont définis dans les sous-revendications.

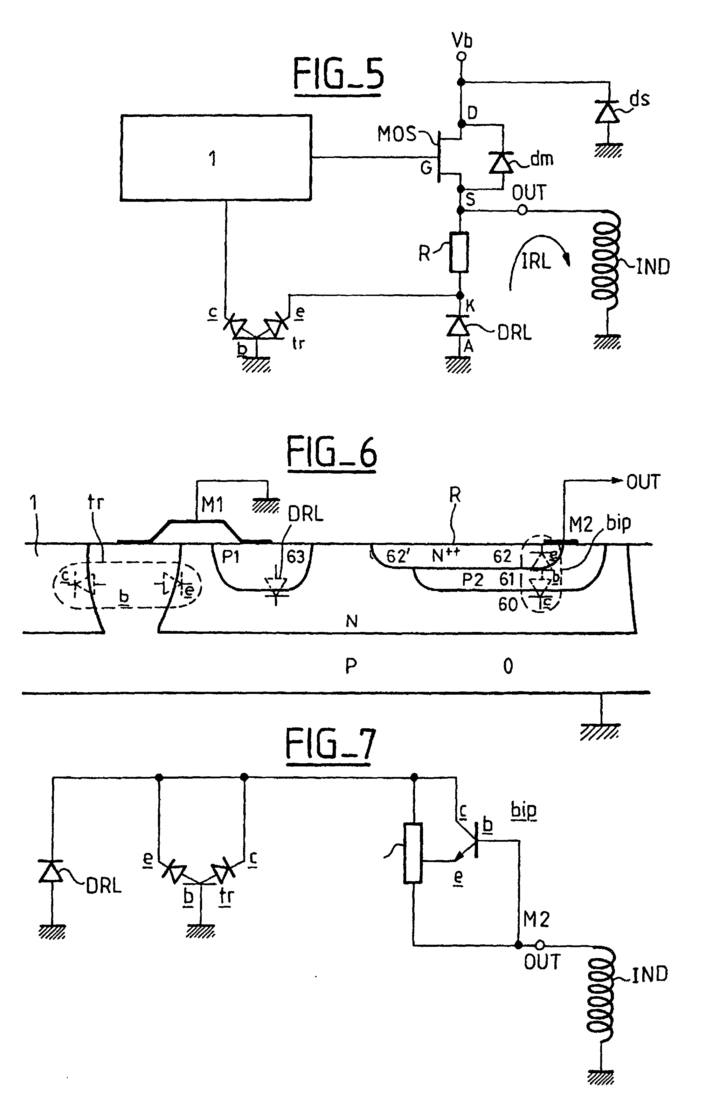

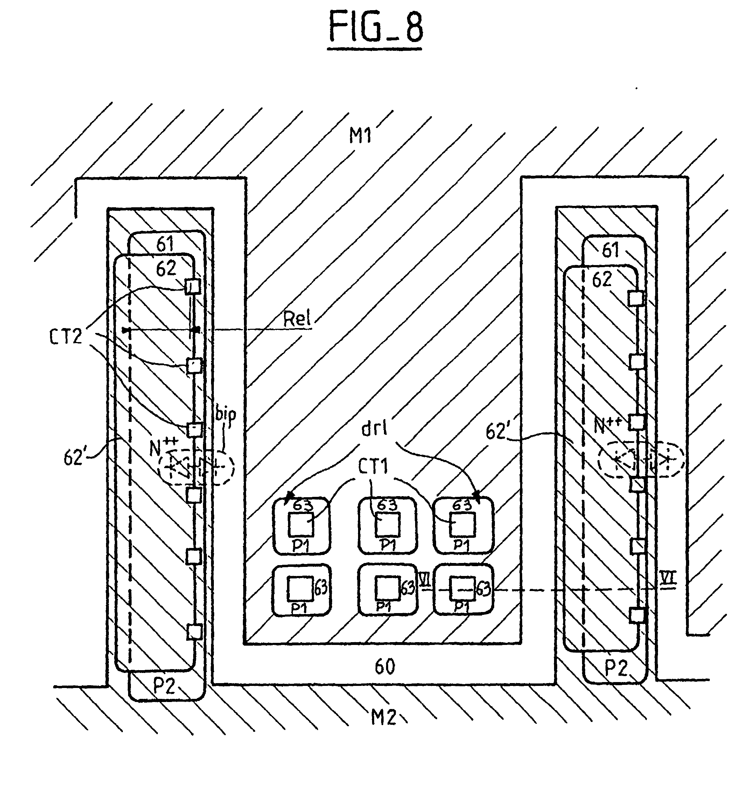

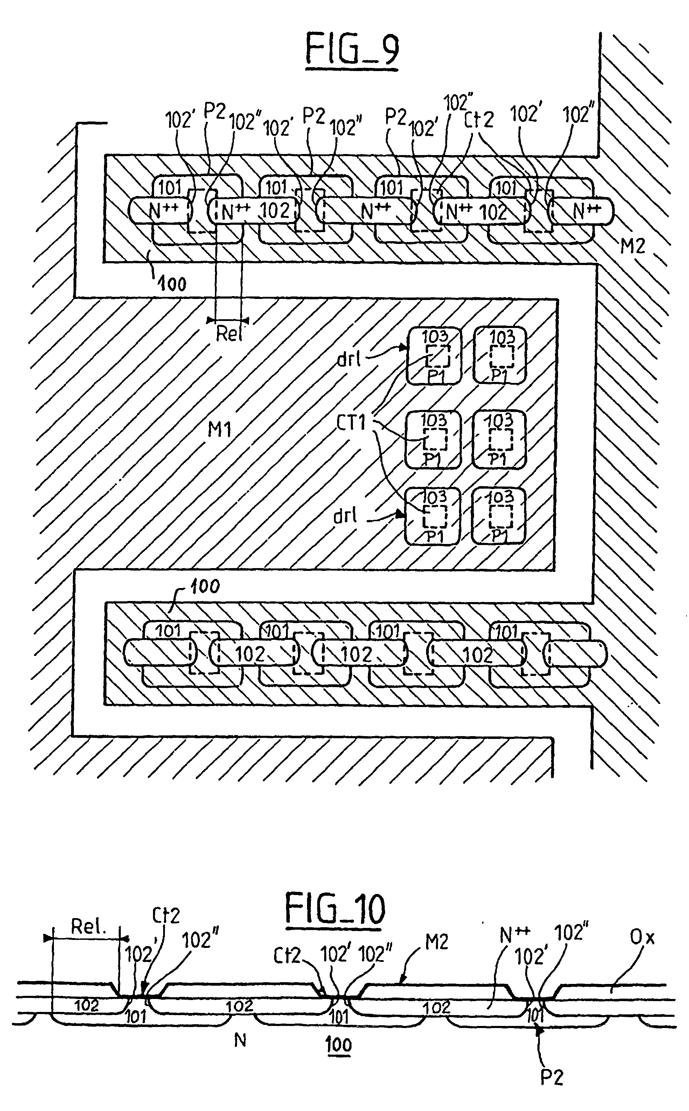

La description qui va suivre et les dessins annexés donnés surtout à titre d'exemples, feront mieux comprendre comment l'invention est réalisée. Sur les dessins annexés :
. la figure 1, précédemment décrite, représente un schéma électrique de régulateur connu ;
. la figure 2, précédemment décrite, représente un schéma électrique équivalent d'un circuit intégré de régulateur connu avec les éléments parasites ;
. la figure 3, précédemment décrite, représente un circuit intégré de régulateur connu vu en coupe au niveau de la diode de roue libre ;
. la figure 4, précédement décrite, représente un circuit intégré de régulateur connu vu en coupe au niveau du transistor à effet de champ ;
. la figure 5 représente un schéma électrique équivalent d'un régulateur selon l'invention ;
. la figure 6 représente un circuit intégré de régulateur selon l'invention, vu en coupe au niveau de la diode de roue libre et de la résistance ;
. la figure 7 représente un schéma électrique équivalent de la diode de roue libre et de la résistance du régulateur selon l'invention ;
. la figure 8 représente un circuit intégré de régulateur selon l'invention, vu de dessus au niveau de la diode de roue libre et de la résistance, dans une première configuration ;
. la figure 9 représente un circuit intégré de régulateur selon l'invention, vu de dessus au niveau de la diode de roue libre et de la résistance, dans une seconde configuration ; et
. la figure 10 représente un circuit intégré de régulateur selon l'invention, en coupe au niveau de la diode de roue libre et de la résistance, dans la seconde configuration.

Maintenant en référence aux dessins, la figure 5 représente un schéma électrique équivalent de circuit intégré selon l'invention.

Ce circuit est constitué de façon semblable à celui de la figure *2,* avec un transistor à effet de champ MOS, commandé par une unité 1, en série avec une diode de roue libre DRL.

Selon l'invention, sur la portion de circuit intégré situé entre l'émetteur e du transistor parasite tr et la borne de sortie OUT, on prévoit de réaliser une résistance R intégrée sur la puce. La résistance R est donc insérée en série entre la borne de sortie OUT et la cathode K de la diode de roue libre DRL.

Pendant le fonctionnement en roue libre, un courant IRL parcourt la boucle de circuit comportant la diode de roue libre DRL, traversée dans le sens direct, la résistance R et l'inductance IND. La jonction base-émetteur b-e du transistor parasite tr est en parallèle uniquement avec la diode de roue libre DRL.

Avantageusement, la valeur ohmique de la diode de roue libre DRL peut être faible. Il suffit pour cela que la diode DRL possède une surface suffisante pour obtenir une faible densité de courant IRL à l'intérieur de la diode. Ainsi, lorsque la diode DRL est traversée par le courant de roue libre IRL, la chute de tension à ses bornes A, K est suffisamment faible pour éviter d'activer la jonction base-émetteur b-e du transistor parasite tr.

D'autre part, lors d'une inversion de polarité, il se produit un courant important entre la masse et la borne Vb, à un potentiel négatif, à travers la diode de roue libre DRL, la résistance R et la diode inverse dm du transistor à effet de champ MOS. Selon l'invention, ce courant est limité par la résistance R, ce qui évite l'échauffement et la destruction du circuit intégré.

Par exemple, le courant inverse qui traverse le circuit selon l'invention est limité à 10 ampères sous une tension inverse de 3,2 Volts, au lieu de 30 ampères dans les circuits précédents. Aussi, les fils métalliques ou bondings qui relient la puce aux broches extérieures sont de conception plus simple. Il n'est plus nécessaire de connecter plusieurs bondings en parallèle, donc la plage de connexion des bondings sur la puce est réduite. La section de ces bondings peut aussi être plus faible.

La figure 5 représente également la diode parasite ds entre le substrat du circuit intégré, qui est relié à la masse, et le drain D du transistor à effet de champ MOS qui est relié au potentiel Vb. Cependant, en inversion de polarité, cette diode parasite ds n'est pas gênante car elle est fortement résistive si la température du silicium reste faible (typiquement inférieure à 100°C). Cette condition de température est remplie par la résistance R qui limite le courant dans les diodes DRL et dm, ce qui limite également l'échauffement du circuit intégré lors de l'inversion de polarité.

La figure 6 illustre un mode de réalisation de l'invention. Une puce en silicium est représentée à la figure 6 par un substrat O, par exemple de type P, qui comporte une résistance R intégrée sur la puce de façon adjacente à la diode de roue libre DRL.

La résistance R est réalisée dans une poche 60 par deux caissons 61 et 62 s'étendant longitudinalement près de la surface de la puce.

Les caissons 61 et 62 s'étendent longitudinalement, parallèlement à la surface de la puce, le caisson 61 étant sous le caisson 62.

Le caisson 62 et la poche 60 sont isolés l'un de l'autre par le caisson 61, sauf à une extrémité longitudinale 62' du caisson 62 qui est en contact avec la poche 60.

Le caisson 62 et la poche 60 ont le même type de conductivité, par exemple une conductivité de type N représentée à la figure 6. Mais le caisson 61 a une conductivité différente, par exemple type P, ce qui permet d'isoler le caisson 62 de la poche 60. Avantageusement, la poche 60 est réalisée par croissance épitaxiale. Tandis que le dopage de chaque caisson est obtenu par diffusion de dopants ou par implantation ionique.

Ainsi, le caisson 62 forme une résistance R longitudinale dont une extrémité 62' est en contact avec la poche 60.

Selon une caractéristique de l'invention donc, cette résistance comporte au moins un premier caisson ayant un premier type de conductivité, réalisé dans une poche ayant un second type de conductivité, au moins un deuxième caisson ayant un second type de conductivité, chaque deuxième caisson étant partiellement inclus dans un premier caisson respectif, de telle sorte qu'un bord d'extrémité du deuxième caisson soit en contact avec la poche.

Une autre extrémité du deuxième caisson est couverte par une métallisation M2 pour être reliée à la borne de sortie OUT. Le caisson 62 forme ainsi une résistance R entre l'extrémité 62' et l'autre extrémité métallisée.

Selon une autre caractéristique, le deuxième caisson 62 a un degré de dopage supérieur à celui de la poche 60. Ainsi, la résistance R peut être diminuée pour obtenir une valeur désirée.

Un effet transistor parasite pourrait apparaître entre cette poche 60 et les deux caissons 61, 62. On voit par exemple à la figure 6, que la poche dopée N, le premier caisson dopé P2 et le deuxième caisson dopé N++ pourraient former un transistor NPN qui court-circuiterait la résistance R formée par le deuxième caisson 62.

Pour éviter cet effet parasite, la métallisation M2 qui couvre déjà une extrémité du caisson 62, est étendue au-dessus d'une partie du premier caisson 61. Ainsi, les deux caissons 61 et 62 sont portés au même potentiel et la jonction base-émetteur du transistor parasite est bloquée. Le circuit équivalent de cette extension de la métallisation M2 est représenté à la figure 7.

Donc, selon une autre caractéristique de l'invention, une métallisation, reliée à la borne de sortie, est en contact avec l'un des premiers caissons et en contact avec l'un des deuxièmes caissons.

Selon une autre caractéristique avantageuse, la diode de roue libre comporte au moins un troisième caisson, ayant un premier type de conductivité, disposé dans la poche ayant un second type de conductivité.

Il est particulièrement intéressant de former la résistance R et la diode de roue libre DRL dans la même poche 60. En effet, on peut ainsi réduire l'espace occupé par les composants en évitant des liaisons supplémentaires pour relier diode DRL et résistance R.

On forme ainsi près de l'extrémité 62' de la résistance R, dans la poche 60, le troisième caisson 63 qui a un dopage adapté pour former une jonction de diode avec la poche 60. Comme le représente la figure 6, le caisson 63 est par exemple réalisé par diffusion de dopant de type P dans la poche 60 de type N.

La branche du circuit de la figure 5 comprenant une résistance R insérée en série entre une diode de roue libre DRL et la borne de sortie OUT est donc réalisée dans une même poche 60 du circuit intégré.

Sur le schéma électrique de la figure 5, le courant de roue libre IRL part de la masse, à laquelle est reliée l'anode A de la diode de roue libre DRL, traverse cette diode, ainsi que la résistance R et est injecté dans l'inductance IND par la borne de sortie OUT.

En fonctionnement, dans le circuit intégré de la figure 6, la masse est reliée par une métallisation M1 au troisième caisson 63 qui forme l'anode A de la diode DRL. Le courant partant de la masse est donc injecté dans le caisson 63 (de type P1 par exemple) puis traverse la jonction (P-N par exemple) de diode DRL pour parvenir dans la poche 60 (type N par exemple).

Le courant entre alors par l'extrémité 62' dans le deuxième caisson 62 qu'il parcourt jusqu'à l'autre extrémité qui est en contact avec la métallisation M2. Le courant est alors injecté dans l'inductance IND par cette métallisation M2 qui est reliée à la borne de sortie OUT.

Le troisième caisson 63 a de préférence des dimensions et un dopage P1 adaptés pour que la jonction caisson 63 - poche 60 soit moins résistive que la jonction substrat O - poche 60. On évite ainsi d'activer la jonction base-émetteur b-e du transistor parasite tr.

De façon connue, pour réduire cet effet transistor parasite, des transistors de puissance sont intégrés dans une région de transistor de la puce de silicium qui est intercalée entre la poche contenant la diode DRL et la résistance R, et la région de commande où est intégrée l'unité de commande 1. Ainsi, le gain de ce transistor parasite tr est diminué car la distance séparant l'émetteur e du collecteur c est fortement augmentée par la région intercalaire de transistor de puissance. Le courant parasite provoqué par cet effet transistor est fortement réduit au niveau de l'unité de commande, et sans effet sur le transistor de puissance.

Aux figures 8 et 9, le circuit intégré est vu de dessus, ce qui permet de montrer deux exemples de configurations avantageuses des caissons, poches et métallisations.

Comme représenté aux figures 8 et 9, une poche unique 60 peut comporter une surface divisée en deux zones de métallisation M1 et M2. La zone de métallisation M1 est imbriquée avec la zone de métallisation M2. Chaque zone est digitée et les doigts formés sont imbriqués en alternant un doigt de métallisation M1 et un doigt de métallisation M2. Ces zones de métallisation sont séparées par un contour sans métallisation pour éviter qu'elles soient en contact.

La diode DRL peut être formée de plusieurs diodes élémentaires drl mises en parallèle. La diode DRL obtenue peut ainsi avoir une grande surface, donc être faiblement résistive. On voit par exemple, au centre de la figure 8, que six troisièmes caissons 63 sont disposés en damier sous un doigt de métallisation M1. Les caissons 63 sont séparés les uns des autres pour avoir une surface de jonction maximum. Des contacts CT1 relient chaque caisson 63 à la métallisation M1, à travers la couche d'oxyde. Ainsi, chaque cellule de diode de roue libre peut comporter plusieurs troisièmes caissons 63, chacun étant en contact avec la métallisation M1.

D'autre part, dans la configuration représentée à la figure 8, chaque doigt de métallisation M2 recouvre une bande longitudinale unique de deuxième caisson 62 couvrant elle-même une bande longitudinale profonde 61 unique de premier caisson. Un bord longitudinal 62' du deuxième caisson 62 couvre et déborde latéralement le premier caisson 61 de façon à être en contact avec la poche 60 sousjacente. Un contact linéaire ou une suite de contacts CT2 lié à la bande de métallisation M2 est disposé sur l'autre bord longitudinal de la bande de deuxième caisson 62. Ces contacts CT2 sont étendus transversalement pour être en contact avec la bande de premier caisson 61 qui remonte le long de ce bord à la surface de la puce. Ainsi, la métallisation M2 est aussi en contact avec la bande profonde de premier caisson 61 pour éviter l'effet transistor parasite bip décrit précédemment et représenté électriquement sur la figure 7.

En coupe transversale, la structure sous le doigt de métallisation M2 est donc similaire à la structure de résistance R représentée en coupe à la figure 6. Ainsi, dans la configuration de la figure 8, une résistance élémentaire Rel unique s'étend transversalement à chaque doigt de métallisation M2, entre un bord de bande de deuxième caisson (bord des contacts CT2) et l'autre bord 62'.

A la figure 9 est représentée une autre configuration. Dans cette variante de la configuration précédente, plusieurs résistances élémentaires Rel s'étendent sous chaque doigt de métallisation M2, dans la direction longitudinale de ce doigt. Ainsi, sous chaque doigt de métallisation M2, sont formés plusieurs premiers et deuxièmes caissons 101, 102 respectivement. Chaque caisson est en contact avec la métallisation M2, tous les caissons étant connectés en parallèle, de sorte que les résistances Rel soient en parallèle.

La disposition des premiers 101 et deuxièmes 102 caissons est une suite de bandes de premiers caissons 101 dans l'axe de chaque doigt de métallisation. Les bandes 101 sont séparées l'une de l'autre par un espace dans lequel le dopage de la poche 100 remonte vers la surface de la puce. Des bandes de deuxièmes caissons 102 sont formées avec le même motif que les bandes de premiers caissons 101. Le motif des bandes 102 est disposé de façon décalée par rapport au motif des bandes 101 de sorte que les bandes de deuxièmes caissons 102 ayant un second type de dopage (par exemple N++) chevauchent les bandes de premiers caissons 101 ayant un premier type de dopage (par exemple P2). De préférence, les bandes de deuxièmes caissons 102 longitudinales sont moins larges que les bandes de premiers caissons 101 qu'elles chevauchent.

Cette structure est mieux comprise à l'aide de la figure 10 qui représente une coupe axiale du doigt de métallisation M2 de la figure 9.

Comme le montre la figure 10, les bandes de premiers caissons 101 sont formées par diffusion de dopant dans la couche épitaxiale 100 de type N. Les bandes de deuxièmes caissons 102, semblables aux bandes de premiers caissons 101 mais ayant un dopage différent, sont diffusées au-dessus de ces bandes 101 en chevauchant l'espace entre les bandes 101. Comme représenté à la figure 10, les bandes de deuxièmes caissons 102 sont moins profondes que les bandes de premiers caissons 101. Elles sont par exemple formées par diffusion de dopage N++ sur une profondeur plus réduite que les bandes 101 ayant un dopage P2. Ainsi, chaque bande de deuxième caisson 102 est en contact avec la poche 100 sur sa partie médiane comprise entre deux bandes de premiers caissons 101 qui sont plus profondes.

Comme décrit précédemment, la métallisation M2 doit être en contact avec une extrémité de chaque bande de deuxième caisson 102 et avec chaque bande de premier caisson 101. Pour ceci, de façon avantageuse, les contacts CT2 sont formés sur toute la partie centrale de chaque bande de premier caisson 101, pour relier la métallisation M2 avec chaque bande de premier caisson 101. En étendant les contacts CT2 longitudinalement, chaque extrémité des bandes de deuxièmes caissons 102 est en contact avec la métallisation M2.

Ainsi on forme une partie résistive Rel le long de chaque demi-longueur de la bande de deuxième caisson 102, entre une extrémité longitudinale 102' et la partie médiane de la bande 102 en contact avec la poche 100. L'autre demi-longueur de la bande 102 comporte aussi une résistance élémentaire Rel entre l'autre extrémité 102" et cette partie médiane. Chaque résistance élémentaire Rel s'étend donc dans la direction longitudinale des doigts représentés à la figure 9.

De façon générale donc, l'invention prévoit qu'une poche puisse comporter des zones comprenant au moins un troisième caisson, intercalées avec des zones comprenant au moins un premier et un deuxième caissons.

Une caractéristique de l'invention prévoit que la réalisation de deuxièmes caissons 62, 102 ayant un second type de dopage N++ et la réalisation de caissons d'émetteurs de transistors bipolaires, sont effectuées au cours d'une étape unique. En effet, le circuit intégré peut comporter des transistors bipolaires dans le circuit de commande 1. Il est avantageux de réaliser ces caissons en une étape, voire de réaliser les caissons par diffusion de dopants à travers un seul masque.

D'autres variantes de réalisation de la présente invention peuvent être envisagées.

Enfin, les conductivités du premier type et du second type correspondent à des dopages du silicium par des impuretés de type N et de type P. Bien entendu, les conductivités N et P donnés à titre d'exemples sur les figures peuvent être modifiées et, en particulier, interverties dans le cas d'un réseau de bord avec le positif à la masse.

## Revendications

1. Circuit intégré, réalisé sur une puce en silicium unique, de régulateur pour l'alimentation d'une inductance (IND) d'excitation d'un alternateur de véhicule automobile, le circuit intégré comportant un substrat d'un premier type de conductivité (P), une borne de sortie (OUT) destinée à être reliée à l'inductance et une première et une seconde bornes d'alimentation (Vb, masse), destinées à être reliées chacune à une borne respective d'une batterie, le circuit comprenant un transistor à effet de champ (MOS) intégré sur la puce, disposé entre la première borne d'alimentation (Vb) et la borne de sortie (OUT), une unité de commande (1) intégrée sur la puce, commandant le transistor à effet de champ, et une diode de roue libre (DRL) intégrée sur la puce, disposée en série entre la seconde borne d'alimentation et la borne de sortie (OUT), et comprenant en outre une résistance (R), intégrée sur la puce de façon adjacente à la diode de roue libre (DRL), insérée entre la diode de roue libre (DRL) et la borne de sortie (OUT), **caractérisé en ce que** le circuit intégré est réalisé en technologie horizontale, avec la borne de sortie (OUT), le première borne d'alimentation (Vb), et la seconde borne d'alimentation (masse) situées sur une même surface du circuit, surface qui est opposée à la surface portant le substrat, et **en ce que** la résistance (R) est réalisée dans une poche (60; 100) d'un second type de conductivité (N) appartenant à la diode de roue libre et comporte au moins un caisson résistif (62; 102), dudit second type de conductivité (N++), chaque caisson résistif étant logé partiellement dans au moins un caisson d'isolement associé (61; 101), du premier type de conductivité et séparé dudit substrat, chaque caisson résistif étant relié à une extrémité à la borne de sortie (OUT) et étant relié, à distance de ladite extrémité, à ladite poche (60; 100) du second type de conductivité.

2. Circuit intégré selon la revendication 1, **caractérisé en ce que** chaque caisson d'isolement (61; 101) est également relié à ladite borne de sortie (OUT).

3. Circuit intégré selon la revendication 1, **caractérisé en ce qu'**une métallisation (M2) appartenant à la borne de sortie (OUT) est en contact avec chaque paire d'un caisson résistif et d'un caisson d'isolement.

4. Circuit intégré selon l'une des revendications 1 à 3, **caractérisé en ce que** la diode de roue libre (DRL) comporte au moins un troisième caisson (63), du premier type de conductivité (P), disposé dans la poche (60).

5. Circuit intégré selon l'une des revendications 1 à 4, **caractérisé en ce que** chaque caisson résistif (62) est fortement dopé.

6. Circuit intégré selon l'une des revendications 1 à 5, **caractérisé en ce qu'**il est prévu des premières zones de métallisation (M1) recouvrant une pluralité de troisièmes caissons (63, 103), intercalées avec des secondes zones de métallisation (M2) en contact avec une pluralité de paires de caissons résistifs et de caissons d'isolement.

7. Circuit intégré selon l'une des revendications 1 à 6, **caractérisé en ce que** le dopage des caissons résistifs et des caissons d'isolement est réalisé par implantation ionique.

8. Circuit intégré selon l'une des revendications 1 à 6, **caractérisé en ce que** le dopage des caissons résistifs et des caissons d'isolement est réalisé par diffusion de dopants.

9. Circuit intégré selon l'une des revendications 1 à 8, **caractérisé en ce que** le dopage de la poche (60, 100) est réalisé par croissance épitaxiale.

10. Circuit intégré selon l'une des revendications 1 à 9, **caractérisé en ce que** les premier et second types de conductivité sont respectivement les types P et N.

11. Circuit intégré selon l'une des revendications 1 à 10, **caractérisé en ce qu'**il comprend en outre un ou plusieurs transistors bipolaires et **en ce que** les caissons résistifs (62, 102) et des caissons d'émetteurs desdits transistors bipolaires sont réalisés au cours d'une même étape.

12. Circuit intégré selon la revendication 11, **caractérisé en ce que** les caissons résistifs (62, 102) et les caissons d'émetteurs sont réalisés par diffusion de dopants à travers un seul masque, au cours de ladite étape.

## Claims

1. Integrated circuit, produced on a single silicon chip, for a regulator for supplying an inductor (IND) exciting a motor vehicle alternator, the integrated circuit comprising a substrate with a first type of conductivity (P), an output terminal (OUT) intended to be connected to the inductor and first and second supply terminals (Vb, earth), each intended to be connected to a respective terminal of a battery, the circuit comprising a field effect transistor (MOS) integrated on the chip, disposed between the first supply terminal (Vb) and the output terminal (OUT), a control unit (1) integrated on the chip, controlling the field effect transistor, and a freewheeling diode (DRL) integrated on the chip, disposed in series between the second supply terminal and the output terminal (OUT), and also comprising a resistor (R), integrated on the chip adjacent to the freewheeling diode (DRL), inserted between the freewheeling diode (DRL) and the output terminal (OUT), **characterised in that** the integrated circuit is produced in horizontal technology, with the output terminal (OUT), the first supply terminal (Vb) and the second supply terminal (earth) situated on the same surface of the circuit, said surface being opposite to the surface carrying the substrate, and **in that** the resistor (R) is produced in a pocket (60; 100) with a second type of conductivity (N) belonging to the freewheeling diode and comprises at least one resistive well (62; 102), with the said second type of conductivity (N++), each resistive well being housed partially in at least one associated insulation well (61; 101), with the first type of conductivity and separated from said substrate, each resistive well being connected at one end to the output terminal (OUT) and being connected, at a distance from the said end, to the said pocket (60; 100) with the second type of conductivity.

2. Integrated circuit according to Claim 1, **characterised in that** each insulation well (61; 101) is also connected to the said output terminal (OUT).

3. Integrated circuit according to Claim 1, **characterised in that** a metallisation (M2) belonging to the output terminal (OUT) is in contact with each pair of a resistive well and an insulation well.

4. Integrated circuit according to one of Claims 1 to 3, **characterised in that** the freewheeling diode (DRL) comprises at least a third well (63), with the first type of conductivity (P), disposed in the pocket (60).

5. Integrated circuit according to one of Claims 1 to 4, **characterised in that** each resistive well (62) is highly doped.

6. Integrated circuit according to one of Claims 1 to 5, **characterised in that** first metallisation areas (M1) are provided, covering a plurality of third wells (63, 103), interposed with second metallisation areas (M2) in contact with a plurality of pairs of resistive wells and insulation wells.

7. Integrated circuit according to one of Claims 1 to 6, **characterised in that** the doping of the resistive wells and insulation wells is carried out by ion implantation.

8. Integrated circuit according to one of Claims 1 to 6, **characterised in that** the doping of the resistive wells and of the insulation wells is carried out by the diffusion of dopants.

9. Integrated circuit according to one of Claims 1 to 8, **characterised in that** the doping of the pocket (60, 100) is carried out by epitaxial growth.

10. Integrated circuit according to one of Claims 1 to 9, **characterised in that** the first and second conductivity types are respectively p and n types.

11. Integrated circuit according to one of Claims 1 to 10, **characterised in that** it also comprises one or more bipolar transistors and **in that** the resistive wells (62, 102) and emitting wells of the said bipolar transistors are produced during one and the same step.

12. Integrated circuit according to Claim 11, **characterised in that** the resistive wells (62, 102) and the emitting wells are produced by the diffusion of dopants through a single mask, during the said step.

## Patentansprüche

1. Integrierte Reglerschaltung, ausgeführt auf einem einzigen Siliziumchip, für die Stromversorgung einer Induktivität (IND) zur Erregung eines Wechselstromgenerators eines Kraftfahrzeugs, wobei die integrierte Schattung ein Substrat eines ersten Leitfähigkeitstyps (p), eine für den Anschluß an die Induktivität bestimmte Ausgangsklemme (OUT) sowie eine erste und eine zweite Speiseklemme (Vb, Masse) umfaßt, die jeweils für den Anschluß an eine entsprechende Batterieklemme bestimmt sind, wobei die Schaltung einen auf dem Chip integrierten Feldeffekttransistor (MOS), der zwischen der ersten Speiseklemme (Vb) und der Ausgangsklemme (OUT) angeordnet ist, eine auf dem Chip integrierte Steuerungseinheit (2), die den Feldeffekttransistor steuert, und eine auf dem Chip integrierte Freilaufdiode (DRL) umfaßt, die zwischen der zweiten Speiseklemme und der Ausgangsklemme (OUT) in Reihe geschaltet ist, und außerdem einen auf dem Chip neben der Freilaufdiode (DRL) integrierten Widerstand (R) enthält, der zwischen der Freilaufdiode (DRL) und der Ausgangsklemme (OUT) eingefügt ist, **dadurch gekennzeichnet, daß** die integrierte Schaltung nach der Horizontaltechnologie ausgeführt ist, wobei sich die Ausgangsklemme (OUT), die erste Speiseklemme (Vb) und die zweite Speiseklemme (Masse) auf einer gleichen Oberfläche der Schaltung befinden, wobei diese Oberfläche der das Substrat tragenden Oberfläche gegenüberliegt, und daß der Widerstand (R) in einer Tasche (60; 100) eines zweiten Leitfähigkeitstyps (n) ausgeführt ist, die zur Freilaufdiode gehört, und wenigstens eine Widerstandswanne (62; 102) des besagten zweiten Leitfähigkeitstyps (n⁺⁺⁺) umfaßt, wobei jede Widerstandswanne teilweise in wenigstens einer zugehörigen Isolierwanne (61; 101) des ersten Leitfähigkeitstyps aufgenommen und von dem besagten Substrat getrennt ist, wobei jede Widerstandswanne an einem Ende mit der Ausgangsklemme (OUT) verbunden ist und in einem Abstand von dem besagten Ende mit der besagten Tasche (60; 100) des zweiten Leitfähigkeitstyps verbunden ist.

2. Integrierte Schaltung nach Anspruch 1, **dadurch gekennzeichnet, daß** jede Isolierwanne (61; 101) außerdem mit der besagten Ausgangsklemme (OUT) verbunden ist.

3. Integrierte Schaltung nach Anspruch 1, **dadurch gekennzeichnet, daß** sich eine zur Ausgangsklemme (OUT) gehörende Metallisierung (M2) mit jedem Paar aus einer Widerstandswanne und einer Isolierwanne in Kontakt befindet.

4. Integrierte Schaltung nach einem der Ansprüche 1 bis 3, **dadurch gekennzeichnet, daß** die Freilaufdiode (DRL) wenigstens eine dritte Wanne (63) des ersten Leitfähigkeitstyps (p) umfaßt, die in der Tasche (60) angeordnet ist.

5. Integrierte Schaltung nach einem der Ansprüche 1 bis 4, **dadurch gekennzeichnet, daß** jede Widerstandswanne (62) stark dotiert ist.

6. Integrierte Schaltung nach einem der Ansprüche 1 bis 5, **dadurch gekennzeichnet, daß** erste Metallisierungsbereiche (M1) vorgesehen sind, die eine Mehrzahl von dritten Wannen (63, 103) überdecken, die mit zweiten Metallisierungsbereichen (M2) ineinandergeschachtelt sind, die sich mit einer Mehrzahl von Paaren aus Widerstandswannen und Isolierwannen in Kontakt befinden.

7. Integrierte Schaltung nach einem der Ansprüche 1 bis 6, **dadurch gekennzeichnet, daß** die Dotierung der Widerstandswannen und der Isolierwannen durch Ionenimplantation erfolgt.

8. Integrierte Schaltung nach einem der Ansprüche 1 bis 6, **dadurch gekennzeichnet, daß** die Dotierung der Widerstandswannen und der Isolierwannen durch Dotierstoffdiffusion erfolgt.

9. Integrierte Schaltung nach einem der Ansprüche 1 bis 8, **dadurch gekennzeichnet, daß** die Dotierung der Tasche (60, 100) durch epitaktisches Aufwachsen erfolgt.

10. Integrierte Schaltung nach einem der Ansprüche 1 bis 9, **dadurch gekennzeichnet, daß** es sich bei den ersten und zweiten Leitfähigkeitstypen um den p-Typ bzw. den n-Typ handelt.

11. Integrierte Schaltung nach einem der Ansprüche 1 bis 10, **dadurch gekennzeichnet, daß** sie außerdem einen oder mehrere bipolare Transistoren umfaßt und daß die Widerstandswannen (62, 102) und die Emitterwannen der besagten bipolaren Transistoren im Verlauf ein und desselben. Arbeitsgangs ausgeführt werden.

12. Integrierte Schaltung nach Anspruch 11, **dadurch gekennzeichnet, daß** die Widerstandswannen (62, 102) und die Emitterwannen durch Dotierstoffdiffusion durch eine einzige Maske hindurch im Verlauf des besagten Arbeitsgangs ausgeführt werden.
